# EUROPEAN PATENT APPLICATION

(11) **EP 1 688 752 A1**
(43) Date of publication of application: **09.08.2006**
(21) Application number: 05019238.4
(22) Date of filing: 05.09.2005
(51) Int. Cl.: G01R 31/3167, H03M 1/10

(54) **Apparatus and method for using mems filters to test electronic circuits**

(30) Priority: 02.02.2005 US 49076
(71) Applicant: Agilent Technologies, Inc., Palo Alto, CA 94306 (US)
(72) Inventor: Weinstein, Michael J., Los Altos, CA 94024 (US); Gurley, Duncan, San Jose, CA 95125 (US)
(74) Representative: Liesegang, Eva

(57) **Abstract**

A mixed-signal integrated circuit testing device (10) includes test electronics (140) for generating a test signal for input to a device under test (50) and receiving a response signal from the device under test (50), and an interface (150) connected between the test electronics (140) and the device under test (50). The interface (150) includes at least one Micro Electro-Mechanical Systems, MEM, filter (160) for filtering an analog signal associated with one of the test signal and the response signal.

## Description

### BACKGROUND OF THE INVENTION

As integrated circuits continue to reach higher levels of performance through shrinking feature sizes, greater integration and higher clock frequencies, manufacturers of integrated circuit testing devices have struggled to improve tester performance while also scaling the cost of the improved testers with the technology. For example, digital integrated circuit testing devices provide hundreds or even thousands of digital test contacts or pins, each providing either clock signals, binary stimulus or capture of binary data to test multiple devices under test (DUTs) in parallel. The testing device also usually includes a DUT interface board that provides the interface between the test electronics and the DUTs. The DUT interface board typically contains thousands of precisely arranged, miniature spring contacts to make the electrical connections with the DUTs. Thus, digital integrated circuit testing devices are traditionally both expensive and complicated.

Mixed-signal integrated circuit testing devices have the additional burdens of providing analog signal stimulus and capturing analog response signals. For example, when testing an analog-to-digital converter (ADC), the test signal is commonly generated by a digital-to-analog converter (DAC) on the testing device, and the digital output of the ADC is captured by the testing device. Likewise, when testing a DAC, the test signal is a digital stream produced by the testing device, and the output of the DAC is an analog signal that is captured by a high-speed ADC on the testing device.

However, the ADC and DAC resources necessary for generation of analog test signals and acquisition of analog output signals add substantial cost to the testing device and consumes expensive "real estate" on the testing device. Mixed-signal resources (i.e., ADCs and DACs) require more space than an equivalent number of digital resources. Thus, the throughput of the testing device is limited by the space available for, and cost of, the mixed-signal resources. In addition, as the density and number of electrical connections increases, the propagation of signals to and from the DUT becomes increasingly problematic.

Therefore, what is needed is a simpler, lower-cost, higher-density, mixed-signal integrated circuit testing device.

### SUMMARY OF THE INVENTION

Embodiments of the present invention provide an apparatus for testing an integrated circuit device under test (DUT) that avoids the need for DACs or high-speed ADCs. The apparatus includes test electronics for generating a test signal for input to the DUT and receiving a response signal from the DUT. The apparatus further includes an interface connected between the test electronics and the DUT. The interface includes at least one microelectromechanical system (MEMS) filter for filtering an analog signal associated with one of the test signal and the response signal.

In one embodiment, to test ADCs on the DUT, the apparatus further includes a signal generator for generating a signal. The MEMS filter filters the signal to produce a filtered signal at the fundamental frequency of the signal. For example, in one exemplary embodiment, the signal generator is a clock generator that produces a clock signal.

In another embodiment, to test DACs on the DUT, the analog signal is the output of the DAC, and the MEMS filter is operable to isolate one or more frequency components of the analog signal to produce a filtered signal. A signal measurement device samples the filtered signal to obtain a measurement of the DAC.

Advantageously, embodiments of the present invention provide a simpler, lower-cost, higher-density, mixed-signal integrated circuit testing device by utilizing MEMS filters to replace DACs and high-speed ADCs. Furthermore, the invention provides embodiments with other features and advantages in addition to or in lieu of those discussed above. Many of these features and advantages are apparent from the description below with reference to the following drawings.

### BRIEF DESCRIPTION OF THE DRAWINGS

The disclosed invention will be described with reference to the accompanying drawings, which show important sample embodiments of the invention and which are incorporated in the specification hereof by reference, wherein:
FIG. 1 is a block diagram of a simplified exemplary integrated circuit testing device, in accordance with embodiments of the present invention;
FIG. 2 is a schematic block diagram of a simplified exemplary testing device for testing digital to analog converters using MEMS filters, in accordance with embodiments of the present invention;
FIG. 3 is a schematic block diagram of a simplified exemplary testing device for testing analog to digital converters using MEMS filters, in accordance with embodiments of the present invention;
FIG. 4 is a schematic block diagram of another simplified exemplary testing device for testing analog to digital converters using MEMS filters, in accordance with embodiments of the present invention;
FIG. 5 is a schematic block diagram of a simplified exemplary testing device for testing digital and analog signals using MEMS filters, in accordance with embodiments of the present invention;
FIG. 6 is a schematic diagram of an exemplary MEMS filter, in accordance with embodiments of the present invention;
FIG. 7 is a cross-sectional view of the exemplary MEMS filter of FIG. 6;
FIG. 8 is a flow chart illustrating an exemplary process for testing an analog to digital converter, in accordance with embodiments of the present invention; and
FIG. 9 is a flow chart illustrating an exemplary process for testing a digital to analog converter, in accordance with embodiments of the present invention.

### DETAILED DESCRIPTION OF THE EXEMPLARY EMBODIMENTS

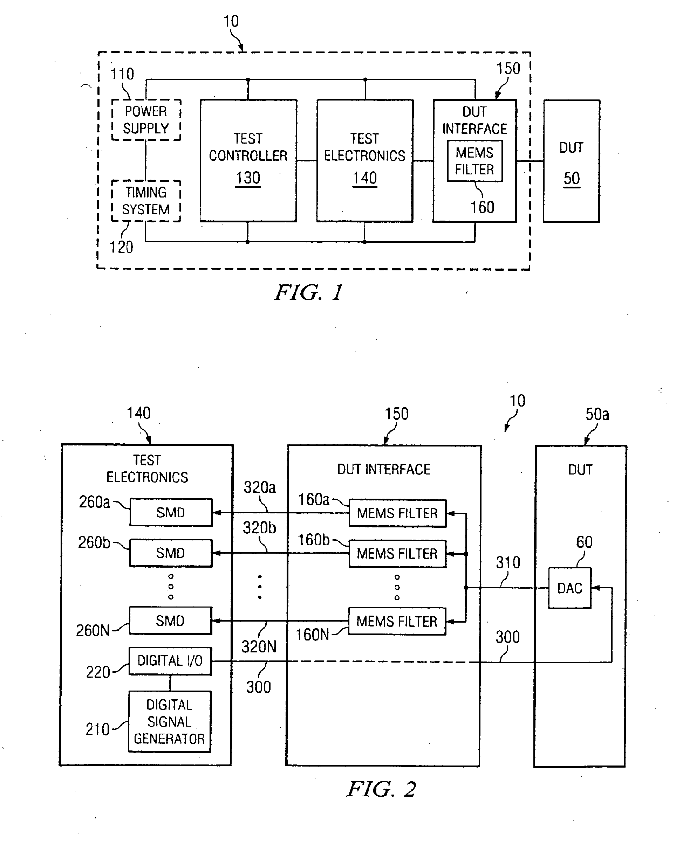

FIG. 1 is block diagram of a simplified exemplary integrated circuit testing device 10, in accordance with embodiments of the present invention. The integrated circuit testing device 10 includes a power supply 110, a timing system 120, a test controller 130, test electronics 140 and a device under test (DUT) interface 150. The DUT interface 150 connects the test electronics 140 to an integrated circuit DUT 50. As used herein, the term DUT refers to one or more integrated circuit devices to be tested. For example, in one embodiment, the DUT interface 150 contains multiple contacts that are each capable of making an electrical connection with one or more devices on the DUT 50. Each of the contacts is connected via internal circuitry in the DUT interface 150 and the test electronics 140 to various measurement devices in the test electronics 140.

The power supply 110 is shown connected to supply power to each of the components 120, 130, 140 and 150 of the testing device 10. However, it should be understood that in other embodiments, separate power supplies can be used supply power to one or more of the components 120, 130, 140 and 150 of the testing device 10. The timing system 120 provides a timing signal to each of the components 130, 140 and 150 of the testing device 10 to synchronize connections made to the DUT 50 and measurements performed by the testing device 10.

The test controller 130 is operable to control the test electronics 140 and the DUT interface 150. For example, in one embodiment, based on input received by the test controller 130, the test controller 130 causes the DUT interface 150 to make one or more connections between contacts on the DUT interface 150 and device terminals on the DUT 50. In addition, the test controller 130 causes the test electronics 140 to apply one or more predetermined test signals to the DUT 50 through the DUT interface 150 connections, and causes the test electronics 140 to compare resulting output signals from the DUT 50 with respective expected values to determine whether the DUT 50 is acceptable or not.

In accordance with embodiments of the present invention, to test an integrated circuit that includes both digital and analog circuit devices, the test electronics 140 is capable of generating a test analog signal and capturing an output analog signal without requiring bulky or expensive DACs or high-speed ADCs. The generation and capture of analog signals is accomplished using narrow bandpass (high-Quality factor (high-Q)) Micro Electro-Mechanical Systems (MEMS) filters 160 on the DUT interface 150. MEMS filters 160 use the natural vibrational frequency of micro-resonantors to transmit precise frequencies, while attenuating noise and other signals at other frequencies. The MEMS filters 160 can be fabricated directly on the DUT interface 150 or mounted onto the DUT interface 150.

The relative size of a MEMS filters 160 is significantly smaller than a conventional passive filter constructed from inductors and capacitors. Therefore, using MEMS filters 160 instead of conventional passive filters not only saves space on the DUT interface 150, but also allows more MEMS filters 160 than conventional filters to be placed on the DUT interface 150, thereby improving test throughput and lowering the cost per test. In addition, the incorporation of high-Q MEMS filters 160 into the DUT interface 150 enables the realization of mixed-signal test functionality while simplifying the mixed-signal hardware by eliminating the need for DACs and reducing the ADC bandwidth or eliminating ADCs altogether. Thus, using MEMS filters 160 on the DUT interface 150 reduces the cost and complexity of the testing device 10.

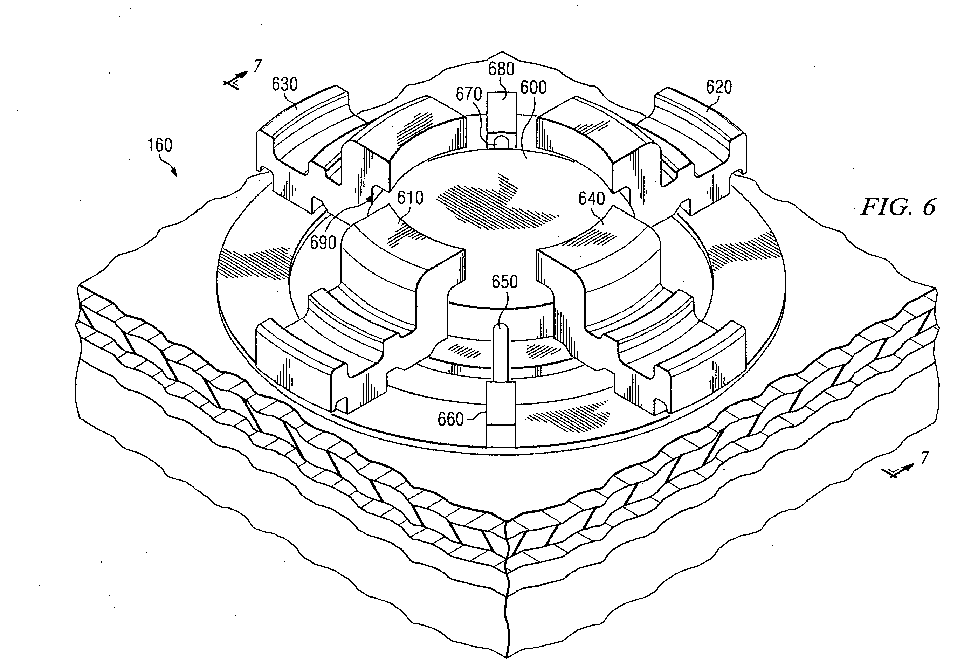

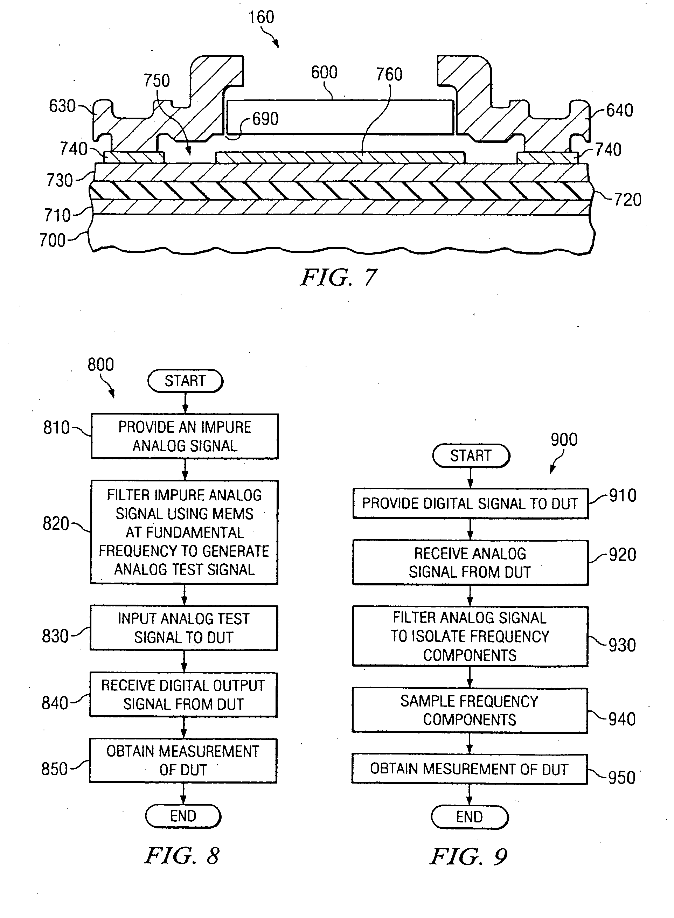

An example of a MEMS filter 160 is shown in FIGs. 6 and 7. The MEMS filter 160 includes a disk resonator 600 suspended over a planar structure 760 by support beams 650 and 670 that are secured by anchors 660 and 680, respectively. Input electrodes 610 and 620 for providing an impure analog signal to the disk resonator 600 and output electrodes 630 and 640 for transmitting an output analog signal are orthogonally positioned adjacent to the disk resonator 600. A gap 690 exists between the disk resonator 600 and each of the electrodes 610, 620, 630 and 640. The support beams 650 and disk resonator 600 collectively form a resonant system that resonates at a resonant frequency. The resonant frequency is inversely proportional to the diameter of the disk resonator 600. For example, in one embodiment, with a disk resonator 600 having a diameter of 64 µm and with a gap 690 of 80 nm, the resonant system produces a resonant frequency of approximately 60 MHz.

The MEMS filter 160 can be fabricated by standard integrated circuit manufacturing processes, such as the one shown in the cross-sectional view of FIG. 7. The MEMS filter 160 is shown fabricated on a p-type silicon substrate 700. An n+ layer 710 is created in the substrate 700 directly below an oxide layer 720. For example, the oxide layer 720 is a layer of SiO₂. A nitride layer 730 is formed above the oxide layer 720, and a layer of polysilicon 740 is formed above the nitride layer 730 to create the planar structure 760 over which the disk resonator 600 is suspended. Typically, another oxide layer is formed above the polysilicon layer 740 in the air gap spaces 750, and a hydrofluoric acid dip is used to remove the oxide once the disk resonator 600, gap 690 and electrodes 630 and 640 are formed. The disk resonator 600 and electrodes 630 and 640 are also formed of polysilicon.

In operation, an alternating electrical signal at a frequency near the resonant frequency of the disk resonator 600 applied between the input electrodes 610 and 620 causes the disk resonator 600 to vibrate at the frequency of the applied alternating electrical signal. The vibration is only significant at or near the resonant frequency.

Vibration of disk 600 induces a voltage between the output electrodes 630 and 640. The mechanical resonance resulting from vibration of disk 100 has a very high-Q, so that the MEMS filter 160 operates to pass electrical signals at the resonant frequency and attenuate any other undesired frequencies. It should be understood that the particular structure of the MEMS filter 160 shown in FIGs. 6 and 7 is for illustration only, and the present invention is not limited to any particular MEMS filter structure.

FIG. 2 is a schematic block diagram of a simplified exemplary testing device 10 for testing digital to analog converters (DACs) 60 using MEMS filters 160, in accordance with embodiments of the present invention. To test the DAC 60 on the DUT 50a, a digital signal 300 produced by a digital signal generator 210 is input to the digital input terminal of the DAC 60 through a digital I/O device 220 and the DUT interface 150. The digital signal 300 causes the DAC 60 to produce an analog output signal 310. To confirm the operation of the DAC 60, the test electronics 140 is set to observe specific frequency components of the analog output signal 310. Therefore, the frequency content of the digital signal 300 is selected to enable the production of the specific frequency components in the analog output signal 310. For example, if a digital signal 300 corresponding to two sinusoids is input to the DAC 60, the specific frequency components that the test electronics 140 would expect to observe for an acceptable DAC 60 are the non-linear products of the two sinusoids. The non-linear products would appear as intermodulation signals at frequencies corresponding to the sums and differences between the input frequencies of the two sinusoids and the sums and differences between the harmonics of these frequencies.

To isolate the desired intermodulation signals, the analog output signal 310 is passed through one or more MEMS filters 160a, 160b ... 160N. Each MEMS filter 160a, 160b ... 160N has a particular resonant frequency determined at the time of manufacture of the MEMS filter. Thus, in one embodiment, the particular MEMS filters 160a, 160b ... 160N that receive the analog output signal 310 are the MEMS filters 160a, 160b ... 160N whose resonant frequencies are equal to one of the desired intermodulation signal frequencies. In another embodiment, the frequency content of the digital signal 300 is selected to produce intermodulation signal frequencies at the known resonant frequencies of particular MEMS filters 160a, 160b ... 160N. Thus, the frequency content of the digital signal 300 input to the DAC 60 can be adjusted for optimum operation with the selected MEMS filters 160a, 160b ... 160N. As a result, a less expensive MEMS filter 160 with a less-precisely defined resonant frequency can be used in embodiments of the present invention.

Each MEMS filter 160a, 160b ... 160N blocks any signal components outside of the narrow passband of the MEMS filter 160a, 160b ... 160N to produce respective filtered signals 320a, 320b ... 320N. The resulting filtered signals 320a, 320b ... 320N are sampled by respective signal measurement devices (SMDs) 260a, 260b ... 260N. For example, in one embodiment, the SMDs 260a, 260b ... 260N are ADCs that sample the resulting filtered signals 320a, 320b ... 320N at a frequency lower than the respective Nyquist frequencies of the filtered signals 320a, 320b ... 320N. In other embodiments, a level comparator, peak detection device or other type of SMD 260 could be used to detect a particular intermodulation signal, instead of an ADC.

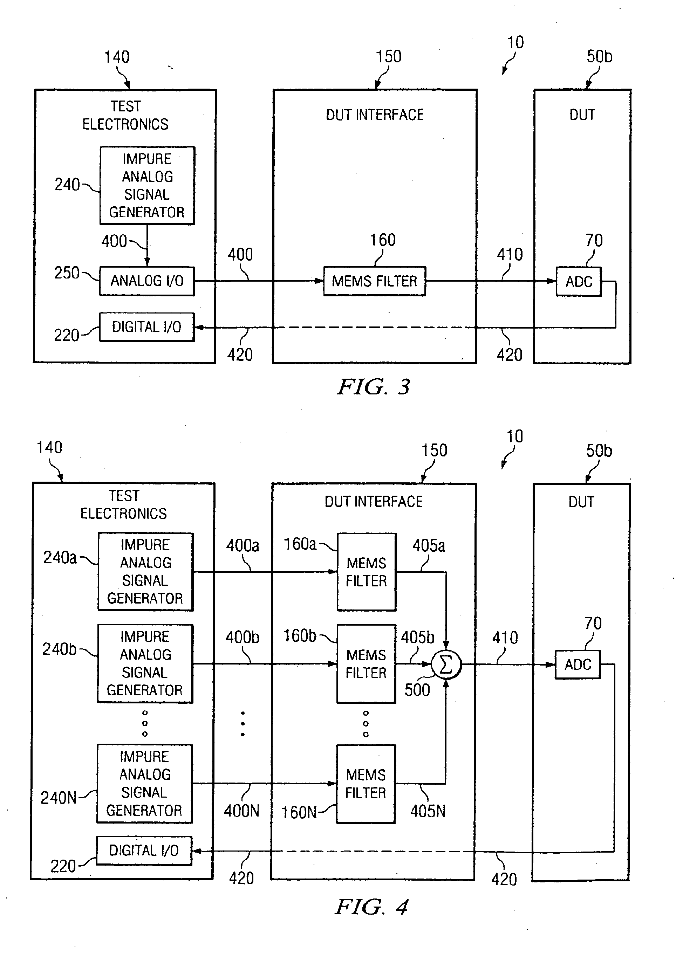

FIG. 3 is a schematic block diagram of a simplified exemplary testing device 10 for testing analog to digital converters (ADCs) 70 using MEMS filters 160, in accordance with embodiments of the present invention. To test the ADC 70 on the DUT 50b, an impure analog signal generator 240 within the test electronics 140 generates an impure analog signal 400 that is passed via an analog I/O device 250 to a high-Q MEMS filter 160 within the DUT interface 150. The high-Q MEMS filter 160 filters the impure analog signal 400 to produce the analog test signal 410. As mentioned above, each MEMS filter 160 on the DUT interface 150 has a particular resonant frequency determined at the time of manufacture of the MEMS filter, which allows the use of MEMS filters 160 that are specific to the test frequency requirements of the ADC 70. Thus, in one embodiment, the particular MEMS filter 160 on the DUT interface 150 that receives the impure analog signal 400 is chosen based on the specific test frequency requirements of the ADC 70. Once the particular MEMS filter 160 having a resonant frequency that lies in the specified test frequency range for the ADC 70 is selected for the ADC 70, the frequency of the impure analog signal 400 produced by the impure analog signal generator 240 is adjusted to fall within the passband of the selected MEMS filter 160. Calibrating the impure analog signal 400 to the resonant frequency of the MEMS filter 160 obviates the need to manufacture the MEMS filter 160 with a precisely defined frequency. As a result, a less expensive MEMS filter 160 can be used in embodiments of the present invention. However, it should be noted that the Q of the selected MEMS filter 160 increases, the passband of the MEMS filter 160 decreases, which requires the frequency of the impure analog signal 400 to be controlled more precisely.

In one embodiment, the impure analog signal 400 is generated by a simple, inexpensive analog oscillator. In other embodiments, the impure analog signal 400 is a digital signal, such as a clock signal. For example, the impure analog signal generator 240 can be a clock generator that produces the clock signal.

The MEMS filter 160 attenuates harmonics and other undesirable signal components from the impure analog signal 400, resulting in an analog test signal 410 having a sinusoidal waveform of high purity. For example, a clock signal 400 typically resembles a square wave made up of a fundamental frequency and harmonic frequencies. The MEMS filter 160 operates to filter the harmonic frequencies to produce the analog test signal 410 with a sinusoidal waveform at the fundamental frequency of the clock signal used as the impure analog signal 400. The analog test signal 410 is input to the analog terminal of the ADC 70 from the DUT interface 150. The analog test signal 410 causes the ADC 70 to produce a digital output signal 420. The digital output signal 420 passes via the DUT interface 150 and the digital I/O device 220 to the test electronics 140.

FIG. 4 is a schematic block diagram of another simplified exemplary testing device 10 for testing ADCs 70 using MEMS filters 160, in accordance with embodiments of the present invention. In FIG. 4, impure analog signal generators 240a, 240b ... 240N within the test electronics 140 each generate a respective impure analog signal 400a, 400b ... 400N that is passed through a respective high-Q MEMS filter 160a, 160a ... 160N within the DUT interface 150 to convert it to a respective sinusoidal analog signal. The resulting sinusoidal analog signals 405a, 405b ... 405N produced by the MEMS filters 160a, 160b ... 160N, respectively, are combined by a summing circuit 500 to produce the analog test signal 410. Thus, the analog test signal 410 input to the analog input terminal of the ADC 70 has a defined complex waveform composed of multiple sinusoidal components each of high purity.

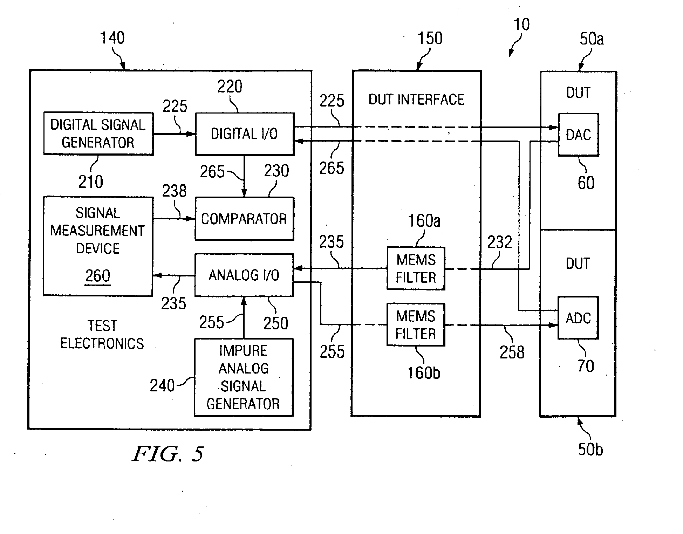

Referring now to FIG. 5, there is illustrated a schematic block diagram of a simplified exemplary testing device 10 for testing digital and analog signals using MEMS filters 160 in accordance with embodiments of the present invention. The test electronics 140 in the testing device 10 includes both a digital input/output (I/O) device 220 (typically one of a plurality of digital I/O devices) that exchanges digital signals with the digital signal terminals of tested devices on DUTs 50a and 50b and an analog I/O device 250 (typically one of a plurality of analog I/O devices) that exchanges analog signals with the analog signal terminals of tested devices on DUTs 50a and 50b. Examples of tested devices shown in FIG. 5 include a digital-to-analog converter (DAC) 60 on the DUT 50a and an analog-to-digital converter (ADC) 70 on the DUT 50b.

In one embodiment, to test the DAC 60, a digital signal generator 210 generates a digital signal 225 that is input to the digital input terminal of the DAC 60 through the digital I/O device 220 and the DUT interface 150. The digital signal 225 causes the DAC 60 to produce an analog output signal 232 that includes sinusoidal waveforms. The analog output signal 232 is measured by a signal measurement device 260 (e.g., an ADC, level comparator, peak detection device or other type of signal measurement device) within the test electronics 140 via the DUT interface 150 and the analog I/O device 250.

In accordance with embodiments of the present invention, instead of utilizing a high-speed ADC that samples at or beyond the Nyquist frequency of the analog output signal 232 to capture the broadband analog response of the DAC 60, the signal measurement device 260 can be a low-speed ADC that samples at a frequency lower than the Nyquist frequency. To accomplish this, the analog output 232 of the DAC 60 is passed through one or more high-Q MEMS filters 160a within the DUT interface 150. Each filter rejects any signal components outside of the narrow passband of the MEMS filter 160a. Each resulting filtered signal 235 is then characterized by sampling the filtered signal 235 at a frequency that is lower than the Nyquist frequency of the analog output signal 232, thus greatly reducing the bandwidth requirements of the ADC.

In embodiments in which the signal measurement device 260 is an ADC, the filtered analog signal 235 is converted into a digital signal 238 by the ADC 260, which is input to a comparator 230 within the test electronics 140. In one embodiment, the comparator 230 is embodied as an electronic circuit for performing the comparison. However, it should be understood that in other embodiments, the comparator 230 can be algorithm or other combination of hardware, software and/or firmware configured to perform the comparison. The comparator 230 compares the digital signal 238 with an expected digital signal to obtain a measurement of the DAC 60. The output of the comparator 230 is used by the test controller 130 (shown in FIG. 1) to determine whether or not the DAC 60 is acceptable.

In another embodiment, to test the ADC 70, an impure analog signal generator 240 within the test electronics 140 generates an impure analog signal 255 that is passed via the analog I/O device to a high-Q MEMS filter 160b within the DUT interface 150. The high-Q MEMS filter 160b filters the impure analog signal 255 to produce the analog test signal 258. In other embodiments, the impure analog signal generator 240 may be located on the DUT interface 150 itself. For example, in one embodiment, the impure analog signal generator 240 is a clock generator that produces a clock signal as the impure analog signal 255. The MEMS filter 160b is selected to attenuate harmonics and other undesirable signal components from the clock signal when used as the impure analog signal 255. The analog test signal 258 is input to the analog input terminal of the ADC 70 from the DUT interface 150.

The analog test signal 258 causes the ADC 70 to produce a digital output signal 265. The digital output signal 265 passes via the DUT interface 150 and the digital I/O device 220 to the comparator 230 within the test electronics 140. The comparator 230 compares the digital output signal 265 with an expected digital signal to obtain a measurement of the ADC 70. The output of the comparator 230 is used by the test controller 130 (shown in FIG. 1) to determine whether or not the ADC 70 is acceptable.

FIG. 8 is a flow chart illustrating an exemplary process 800 for testing an analog to digital converter (ADC), in accordance with embodiments of the present invention. Initially, the testing device generates an impure analog signal and passes the impure analog signal through a high-Q MEMS filter to produce an analog test signal at the frequency of the impure analog signal (blocks 810 and 820). Thereafter, the analog test signal is input to the ADC (block 830). The analog test signal causes the ADC to produce a digital output signal that is received by the testing device (block 840). The testing device uses the received digital output signal to obtain a measurement of the ADC to determine whether or not the ADC is acceptable (block 850).

FIG. 9 is a flow chart illustrating an exemplary process 900 for testing a digital to analog converter (DAC), in accordance with embodiments of the present invention. Initially, the testing device provides a digital signal to the digital terminal of the DAC (block 910). The digital signal causes the DAC to produce an analog output signal that is received by the testing device (block 920). To confirm the operation of the DAC, the analog output signal is passed through one or more MEMS filters to isolate specific frequency components of the analog output signal (block 930). The filtered frequency components are tested (e.g., by an ADC at a frequency lower than the Nyquist frequency of the analog output signal) to obtain a measurement of the DAC (blocks 940 and 950).

The innovative concepts described in the present application can be modified and varied over a wide rage of applications. Accordingly, the scope of patents subject matter should not be limited to any of the specific exemplary teachings discussed, but is instead defined by the following claims.

## Claims

1. An apparatus for testing an integrated circuit device under test, comprising:
test electronics (140) for generating a test signal for input to the device under test (50) and receiving a response signal from the device under test (50); and
an interface (150) connected between said test electronics (140) and the device under test (50), said interface (150) including a Micro Electro-Mechanical Systems (MEMS) filter (160) for filtering an analog signal associated with one of the test signal and the response signal.

2. The apparatus of Claim 1, wherein said test electronics (140) includes a digital signal generator (210) for generating a digital signal (225), and wherein the device under test (50) is a digital to analog converter (60), the analog signal is the response signal (232) produced by the digital to analog converter (60) in response to receipt of the digital signal (225), and said MEMS filter (160) is operable to isolate a frequency component of the analog signal to produce a filtered signal (235).

3. The apparatus of Claim 2, wherein said filtered signal (235) comprises at least one intermodulation signal (320a, 320b ... 320N), each at a frequency corresponding to a sum or difference between two input frequencies.

4. The apparatus of Claim 2, wherein said test electronics (140) further includes a signal measurement device (260) operable to test said filtered signal (235) to obtain a measurement of the digital to analog converter (60).

5. The apparatus of Claim 1, wherein said test electronics (140) includes an impure analog signal generator (140) for generating an impure analog signal (255), and wherein the device under test (50) is an analog to digital converter (70), the impure analog signal (255) is the analog signal filtered by said MEMS filter (160) and said MEMS filter (160) is operable to produce the test signal (258) at the fundamental frequency of the impure analog signal (255).

6. The apparatus of Claim 5, wherein said impure analog signal generator (240) includes impure analog signal generators (240a, 240b ... 240N), each for generating a respective impure analog signal (400a, 400b ... 400N), and wherein said MEMS filter (160) includes MEMS filters (160a, 160b ...160N), each connected to filter a respective one of said impure analog signals (400a, 400b ... 400N) and produce a respective filtered signal (405a, 405b ... 405N), and further comprising:
a summing circuit (500) connected to combine said filtered signals (405a, 405b ... 405N) to produce the test signal (410).

7. A method for testing a device under test, the method comprising:
providing a Micro Electro-Mechanical Systems (MEMS) filter (160) capable of receiving and filtering an analog signal associated with the device under test (50);
for a device under test that is an analog to digital converter (70):
receiving (810) the analog signal (255) at the MEMS filter (160) from a testing device (140);
filtering (820) the analog signal (255) to produce a filtered signal (258) at the fundamental frequency of the analog signal (255), and
providing (830) the filtered signal (258) to the analog to digital converter (70); and
for a device under test that is a digital to analog converter (60):
receiving (920) the analog signal (232) at the MEMS filter (160) from the digital to analog converter (60);
filtering (930) the analog signal (232) to isolate a frequency component (235) thereof, and
providing (940 and 950) the isolated frequency component (235) to the testing device (140).

8. The method of Claim 7, wherein said receiving (810) the analog signal (255) at the MEMS filter (160) from the testing device (140) includes generating impure analog signals (400a, 400b ... 400N); said filtering (820) the analog signal (255) to produce the filtered signal (258) at the fundamental frequency of the analog signal (255) comprises filtering each of said impure analog signals (400a, 400b ... 400N) with a respective MEMS filter (160a, 160b ... 160N) to produce a respective filtered signal (405a, 405b ... 405N); and said method further comprises combining said filtered signals (405a, 405b ... 405N) to produce the analog test signal (410).

9. The method of Claim 7, wherein said filtering (820) the analog signal (255) to produce the filtered signal (258) at the fundamental frequency of the analog signal (255) includes adjusting the frequency of the analog signal (255) to a resonant frequency of the MEMS filter (160).

10. The method of Claim 7, wherein said filtering (932) the analog signal (232) to isolate the frequency component (235) thereof includes passing the analog signal (310) through MEMS filters (160a, 160b ... 160N) to isolate respective intermodulation signals (320a, 320b ... 320N); and said method further comprises measuring each of the intermodulation signals (320a, 320b ... 320N).
